# FASCICULE DE BREVET EUROPEEN

(11) **EP 3 142 471 B1**
(45) Date de publication et mention de la délivrance du brevet: **29.03.2023**
(21) Numéro de dépôt: 16181789.5
(22) Date de dépôt: 28.07.2016
(51) Int. Cl.: H05K 9/00

(54) **SUPPORT COMPORTANT UN COMPOSANT RECOUVERT D'UN BLINDAGE**
TRÄGER, DER EINE MIT EINER PANZERUNG BEDECKTE KOMPONENTE UMFASST
MOUNTING COMPRISING A COMPONENT COVERED WITH A SHIELD

(30) Priorité: 08.09.2015 FR 1558324
(43) Date de publication de la demande: 15.03.2017
(73) Titulaire: SAGEMCOM ENERGY & TELECOM SAS, 92500 Rueil-Malmaison (FR)
(72) Inventeur: LHUILLIER, Pierre, 92500 Rueil Malsaison (FR); DE LA CRUZ, Fabien, 92500 Rueil Malmaison (FR); DONNENWIRTH, Freddy, 92500 Rueil Malmaison (FR); TISNE, Alain, 92500 Rueil Malmaison (FR)
(74) Mandataire: Decorchemont, Audrey Véronique Christèle

(56) Documents cités:
- DE-B3-102011 016 480
- US-A1- 2011 044 019

## Description

Support comportant un composant recouvert d'un blindage L'invention concerne un support comprenant au moins un composant ainsi qu'un blindage électronique ou électrique dudit composant.

### ARRIERE PLAN TECHNOLOGIQUE DE L'INVENTION

Les cartes à circuits imprimés des équipements à forte densité électronique comportent usuellement plusieurs zones séparées par isolation galvanique et des composants mettant en œuvre différentes technologies répartis entre ces zones.

Or ces différents composants peuvent générer des bruits parasites tels que des champs électromagnétiques parasites pouvant perturber le comportement des composants voisins ayant une autre technologie.

En particulier, les cartes à circuits imprimés qui incorporent des composants sensibles de technologie radio de type 2G/3G/4G comportent en outre usuellement un ou plusieurs isolateurs numériques, et plus particulièrement des isolateurs numériques USB, qui sont agencés au niveau de l'isolation galvanique et qui permettent d'établir un lien entre deux microcontrôleurs ou microprocesseurs situés sur des zones différentes de la carte à circuit imprimé séparées par isolation galvanique. Or ces isolateurs numériques s'avèrent particulièrement bruyants sur une large gamme de fréquences et notamment dans les gammes de fréquences des composants de technologie radio 2G/3G/4G. En outre, dans la plupart des équipements à forte densité électronique incorporant une telle carte à circuit imprimé, la compacité de l'équipement nécessite une proximité physique entre les isolateurs numériques et l'antenne radio de l'équipement. Ceci implique une dégradation sensible des performances radio de l'antenne, notamment en réception, de plusieurs décibels, voire dizaines de décibels.

Les documents DE 10 2011 016480 B3 et US 2011/044019 A1 concernent des exemples de cartes électroniques comprenant des composants blindés.

### OBJET DE L'INVENTION

Un but de l'invention est de proposer un support permettant de limiter les bruits parasites émis par un composant dudit support même lorsque le composant est agencé sur une isolation galvanique du support.

### BREVE DESCRIPTION DE L'INVENTION

En vue de la réalisation de ce but, on propose un support tel que défini dans la revendication indépendante.

Selon l'invention, le blindage comprend au moins deux structures distinctes en matériau électriquement conducteur qui sont agencées pour recouvrir sans se toucher au moins une face principale du composant, chaque structure comportant une portion en matériau électriquement conducteur qui s'étend au-dessus de la face principale du composant en regard de la portion correspondante de l'autre structure le blindage comporte en outre au moins une couche en matériau électriquement isolant s'étendant entre les deux portions pour former avec lesdites portions une capacité, où la couche en matériau électriquement isolant s'étend à l'extérieur d'au moins l'une des portions pour englober au moins ladite portion.

De la sorte, le blindage entoure le composant ce qui permet de circonscrire les bruits parasites tels qu'un champ électromagnétique parasite rayonné par le composant. On limite ainsi la perturbation que pourrait causer le composant à d'autres composants du support. Ceci s'avère particulièrement avantageux pour les supports de type cartes à circuits imprimés d'équipements à forte densité électronique notamment celles incorporant de la technologie radio fréquence comme par exemple les standards 2G et/ou 3G et/ou 4G.

En outre, les portions en regard du blindage créent une capacité qui autorise les particules chargées à circuler d'une portion à une autre pour une certaine gamme de fréquences. Ceci permet de refermer virtuellement les deux portions en regard, pour cette gamme de fréquences, par l'intermédiaire de la capacité améliorant dès lors l'efficacité du blindage. Le dimensionnement du blindage (notamment par choix de la géométrie et des matériaux utilisés pour le blindage) permet de sélectionner la gamme de fréquences que va laisser passer la capacité. On peut ainsi sélectionner la gamme de fréquences en fonction de l'application du support et des contraintes spécifiques au support.

Par ailleurs, l'agencement astucieux du blindage permet également d'assurer un blindage complet de la face principale du composant, soit la face la plus génératrice de bruits parasites, sans continuité entre les différentes structures électriquement conductrices du blindage. Ceci s'avère particulièrement utile lorsque le composant est agencé à cheval sur différentes zones du support séparées par isolation galvanique, le blindage permettant ainsi de respecter cette isolation galvanique.

Pour la présente demande, par « isolation galvanique », on entend que les différentes zones du support séparées par une telle isolation ne sont reliées physiquement par aucun élément conducteur d'électricité. On note que les portions en regard du blindage formant la capacité respectent ce critère puisqu'elles ne se touchent pas et sont en outre espacées. Le « composant » à cheval sur ces différentes zones rempli donc également ce critère. Le composant peut ainsi être par exemple un optocoupleur ou encore un isolateur numérique.

Pour la présente demande, par « face principale du composant », on entend la face du composant opposée à celle reposant contre le support.

Par « surface de recouvrement », on entend la surface qui est commune à deux portions s'étendant en regard l'une de l'autre.

### BREVE DESCRIPTION DES DESSINS

L'invention sera mieux comprise à la lumière de la description qui suit de modes de réalisation non limitatifs de l'invention en référence aux figures ci-jointes, parmi lesquelles :
- la figure 1 est une vue en coupe de côté du support selon un premier mode de réalisation de l'invention ;
- la figure 2 est une vue en coupe de côté du support selon un deuxième mode de réalisation de l'invention;
- la figure 3 est une vue en coupe de côté du support selon un troisième mode de réalisation de l'invention;
- la figure 4 est une vue en coupe de côté du support selon un quatrième mode de réalisation de l'invention ;
- la figure 5 est une vue en coupe de côté du support selon un cinquième mode de réalisation de l'invention ;
- la figure 6 est une vue en coupe de côté du support selon un sixième mode de réalisation de l'invention :
- la figure 7 est une vue en coupe de côté du support selon un septième mode de réalisation de l'invention.

### DESCRIPTION DETAILLEE DE L'INVENTION

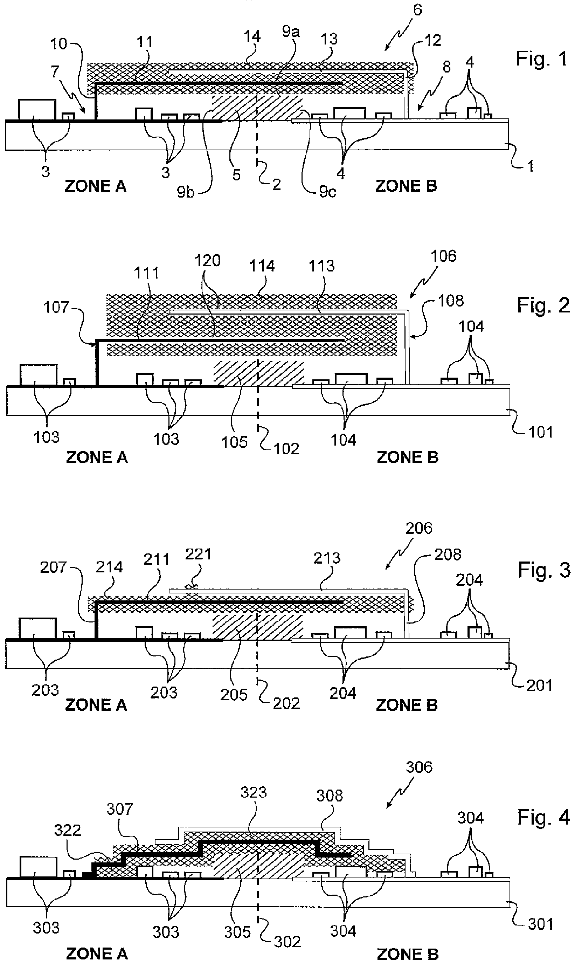

En référence à la figure 1, le support selon le premier mode de réalisation est ici une carte à circuit imprimé 1.

De façon particulière, la carte à circuit imprimé 1 comprend une première zone A et une deuxième zone B qui sont séparées entre elles par isolation galvanique (schématisée ici en pointillées et référencée 2). La carte à circuit imprimé 1 comporte ainsi différents composants 3 agencés sur la première zone A et différents composants 4 agencés sur la deuxième zone B ainsi qu'un composant 5 agencé sur les deux zones au niveau de la frontière entre les deux zones, ledit composant 5 étant alors constitué pour respecter l'isolation galvanique 2 entre lesdites deux zones.

De façon particulière, le composant 5 est un isolateur numérique et les différents autres composants de la carte à circuit imprimé comportent entre autres de la technologie 2G et/ou 3G et/ou 4G. L'isolateur numérique 5 ayant tendance à générer beaucoup de bruits notamment aux fréquences radio 2G et 3G, il convient d'empêcher ces bruits de perturber les autres composants de la carte à circuit imprimé 1 permettant de générer et de recevoir de telles fréquences radio.

A cet effet, la carte à circuit imprimé 1 comporte un blindage 6 de l'isolateur numérique 5. De façon particulière, le blindage 6 comporte une première structure 7 agencée sur la première zone A et reliée à un potentiel de référence de la première zone A et une deuxième structure 8, distincte de la première structure 7, agencée sur la deuxième zone B et reliée à un potentiel de référence de la deuxième zone B.

Les deux structures 7, 8 sont en matériau électriquement conducteur. Les deux structures 7, 8 sont agencées pour recouvrir ensemble sans se toucher une face principale 9a de l'isolateur numérique, une première face latérale 9b de l'isolateur numérique et une deuxième face latérale 9c de l'isolateur numérique, opposée à la première face latérale 9b. Les deux structures 7, 8 sont par exemple ici en acier.

La première structure 7 comporte ici une première portion 10 qui s'étend à partir de la première zone A en regard de l'isolant numérique 5 jusqu'au-dessus de l'isolant numérique 5 et une deuxième portion 11 qui s'étend à partir de la première portion 10 au-dessus de la face principale 9a de l'isolateur numérique 5. Les deux portions 10, 11 s'étendent ici sensiblement à la perpendiculaire l'une de l'autre.

La première portion 10 présente une surface supérieure à la surface de la première face latérale 9b de l'isolateur numérique 5 de sorte à recouvrir toute la première face latérale 9b de l'isolant numérique 5. La première portion 9a est ici une surface plane.

La deuxième portion 11 s'étend ici depuis la première zone A jusqu'à la deuxième zone B, en restant au-dessus de la première zone A et de la deuxième zone B. la deuxième portion 11 s'étend ainsi de sorte à avoir une surface supérieure à la surface de la face principale 9a de l'isolateur numérique 5. La deuxième portion 11 recouvre donc toute la face principale 9a de l'isolateur numérique 5. La deuxième portion 11 est ici une surface plane. La deuxième portion 11 s'étend parallèlement à la carte à circuit imprimé 1 et plus précisément ici à l'isolateur numérique 5.

De façon particulière, la deuxième structure 8 comporte une troisième portion 12 qui s'étend à partir de la deuxième zone B en regard de l'isolant numérique 5 jusqu'au-dessus de l'isolant numérique 5 et une quatrième portion 13 qui s'étend à partir de la troisième portion 12 au-dessus de la face principale 9a de l'isolateur numérique 5. La troisième portion 12 et la quatrième portion 13 s'étendent ici sensiblement à la perpendiculaire l'une de l'autre.

La troisième portion 12 présente une surface supérieure à la surface de la deuxième face latérale 9c de l'isolateur numérique 5 de sorte à recouvrir toute la deuxième face latérale 9c de l'isolant numérique. La troisième portion 12 est ici une surface plane.

La quatrième portion 13 s'étend ici depuis la deuxième zone B jusqu'à la première zone A, en restant au-dessus de la première zone A et de la deuxième zone B et de la deuxième portion 11. La quatrième portion 13 s'étend ainsi de sorte à avoir une surface supérieure à la surface de la face principale 9a de l'isolateur numérique 5. La quatrième portion 13 recouvre donc toute la face principale 9a de l'isolateur numérique 5. La quatrième portion 13 est ici une surface plane. La quatrième portion 13 s'étend parallèlement à la carte à circuit imprimé 1 et plus précisément ici à l'isolateur numérique 5.

La deuxième portion 11 et la quatrième portion 13 sont donc agencées de sorte que la deuxième portion 11 et la quatrième portion 13 s'étendent au-dessus de la face principale 9a de l'isolateur numérique 5 parallèlement l'une à l'autre. De la sorte, la deuxième portion 11 et la quatrième portion 13 comportent des surfaces en regard l'une de l'autre ce qui permet de former une capacité au niveau desdites surfaces.

Le blindage 6 comporte en outre une couche en matériau électriquement isolant 14 qui est donc solide.

Ainsi, la couche en matériau électriquement isolant 14 assure un meilleur maintien mécanique du blindage 6 en limitant notamment un fléchissement des extrémités libres des portions 11, 13. En outre, comme ici le composant se trouve en plus à cheval sur différentes zones du support séparées par isolation galvanique, l'utilisation de la couche en matériau électriquement isolant 14 permet de limiter l'encombrement du blindage. Il n'est en effet pas nécessaire d'avoir une distance très importante entre des portions 11, 13 en regard du blindage 6 pour respecter l'isolation galvanique du fait du caractère isolant de la couche en matériau électriquement isolant 14.

La couche en matériau électriquement isolant 14 est ici agencée de sorte à s'étendre non seulement entre la deuxième portion 11 et la quatrième portion 13 mais également à l'extérieur desdites portions de sorte à englober la deuxième portion 11 et la quatrième portion 13.

Ainsi on peut agencer aisément d'autres éléments au-dessus de la quatrième portion 13 (comme une autre carte à circuit imprimé) tout en évitant la rupture de l'isolation galvanique 2. On note que la couche en matériau électriquement isolant 14 fait également partie de la capacité formée par la deuxième portion 11 et la quatrième portion 13 en tant qu'isolant central de ladite capacité.

De façon particulière, la deuxième portion 11 et la quatrième portion 13 sont directement surmoulées par la couche en matériau électriquement isolant 14. La couche en matériau électriquement isolant 14 est ainsi rigidement fixée à la deuxième portion 11 et à la quatrième portion 13. La couche en matériau électriquement isolant 14 et la première structure 7 et la deuxième structure 8 forment donc un tout-rigide.

Ceci permet une bonne maîtrise et reproductibilité de la géométrie et des caractéristiques du blindage 6 de sorte que la production du blindage 6 peut être automatisée relativement aisément. Il s'avère en outre simple de lier ensuite le tout-rigide à la carte à circuit imprimé 1.

Le blindage 6 permet ainsi de circonscrire les perturbations rayonnées par l'isolateur numérique 5 tout en respectant l'isolation galvanique 2 du fait de l'absence de contact direct entre les deux structures 7, 8 et de la séparation supplémentaire par la couche en matériau électriquement isolant 14.

De préférence, le matériau de la couche en matériau électriquement isolant 14 présente une forte résistivité volumique et une forte constante diélectrique (permittivité). On limite ainsi les dimensions de la couche en matériau électriquement isolant 14, et par là du blindage 6, tout en respectant l'isolation galvanique 2. La couche en matériau électriquement isolant 14 est ici en polyamide renforcé en fibres de verre, matériau adapté au surmoulage de la deuxième portion 11 et la quatrième portion 13 par ladite couche en matériau électriquement isolant.

Le blindage 6 est ici conformé pour bloquer principalement les rayonnements parasites de hautes fréquences (de quelques dizaines de Mégahertz à quelques Gigahertz) générés par l'isolateur numérique 5. De préférence ici, le blindage 6 est conformé pour bloquer principalement les rayonnements parasites de l'isolateur numérique 5 de l'ordre du Gigahertz (par exemple entre 0,5 et 2.5 Gigahertz) ce qui correspond aux rayonnements parasites particulièrement gênants pour la technologie radio sensible 2G et/ou 3G et/ou 4G de la carte à circuit imprimé 1.

De préférence, on dimensionne en conséquence l'épaisseur des portions. Le blindage 6 est donc conformé de sorte que l'épaisseur des quatre portions 10, 11, 12, 13 soit supérieure à l'épaisseur de peau desdites portions afin d'éviter que les ondes électromagnétiques rayonnées ne traversent lesdites portions vers l'extérieur. Les différentes portions étant ici en acier, on rappelle que l'épaisseur de peau de l'acier pour des fréquences de l'ordre du Gigahertz est d'environ 0.2 micromètre. Les différentes portions sont donc ici conformées de sorte à présenter une épaisseur d'au moins quelques centaines de micromètres afin d'être également d'une épaisseur suffisamment importante pour assurer une rigidité mécanique suffisante des deux structures 7, 8.

De préférence, le blindage 6 est également conformé de sorte que la capacité créée par la deuxième portion 11 et la quatrième portion 13 et la couche en matériau isolant 14 permet aux particules chargées de circuler de la première zone A à la deuxième zone B pour les fréquences de l'ordre du Gigahertz.

Ceci permet de refermer virtuellement la deuxième portion 11 et la quatrième portion 13 par l'intermédiaire de la capacité pour les fréquences de l'ordre du Gigahertz. En outre, on limite ainsi la différence de potentiel de part et d'autre de l'isolateur numérique 5 réduisant ainsi les rayonnements parasites émis par l'isolateur numérique 5.

Il convient donc de conformer le blindage 6 pour que la valeur de la capacité réalisée autorise le passage de ces particules chargées. A cet effet, on dimensionne le blindage 6 en s'attachant à la distance séparant la deuxième portion 11 et la quatrième portion 13 (« e »), à la surface de recouvrement entre la deuxième portion 11 et la quatrième portion 13 (« S ») et au matériau de la couche en matériau électriquement conducteur 14 séparant la deuxième portion 11 et la quatrième portion 13 en fonction de sa permittivité (« ε »), étant rappelé que la valeur d'une capacité (« C ») est liée à ces trois paramètres. Dans le cas présent, du fait que la deuxième portion 11 et la quatrième portion 13 en regard sont planes et parallèles, la capacité est ainsi donnée par la formule: *C* = ε(*S*/*e*).

Le matériau de la couche en matériau électriquement isolant étant en en polyamide renforcé en fibres de verre de permittivité d'environ 33 picofarads par mètre (permittivité relative d'environ 3.8), le blindage 6 est ici conformé de sorte que la deuxième portion 11 et la quatrième portion 13 présentent des surfaces de recouvrement en regard de 5 centimètres carrés qui sont séparées d'une distance de 0.5 millimètres. Ceci donne une capacité ayant une valeur d'environ 33 picofarad, capacité efficace pour les gammes de fréquences de l'ordre du Gigahertz.

Par ailleurs, le blindage 6 est de préférence conformé de sorte que toutes les ouvertures du blindage 6 (comprenant donc ici les ouvertures au niveau de deux des quatre faces latérales de l'isolant numérique 5 et au niveau de la face reposant contre la carte à circuit imprimé 1) présentent des dimensions inférieures aux longueurs d'ondes des rayonnements que l'on souhaite cloisonner à l'intérieur du blindage 6 soit ici des longueurs d'ondes d'ordre de 30 centimètres (typiquement entre 12 et 60 centimètres). De préférence, le blindage 6 est conformé de sorte que toutes les ouvertures du blindage 6 présentent des dimensions au moins quatre fois inférieure aux longueurs d'ondes des rayonnements que l'on souhaite cloisonner à l'intérieur du blindage 6.

Le blindage 6 est ainsi ici conformé de sorte que les différentes ouvertures du blindage 6 aient comme dimensions maximales une dimension inférieure à 3 centimètres.

De la sorte, on limite le risque que les ouvertures laissent échapper une partie des ondes parasites.

Le blindage 6 ainsi conformé s'avère donc particulièrement efficace pour les fréquences de l'ordre du Gigahertz.

En référence à la figure 2, la carte à circuit imprimé 101 selon le deuxième mode de réalisation de l'invention s'avère identique à celle du premier mode de réalisation à la différence près que la couche en matériau électriquement isolant 114 n'est pas surmoulée sur la deuxième et la quatrième portion mais comporte des fentes 120 ménagées dans ladite couche en matériau électriquement isolant 114 dans lesquelles sont insérées la deuxième portion 111 et la quatrième portion 113 de façon à lier la couche en matériau électriquement isolant 114 à la deuxième portion 111 et la quatrième portion 113.

Ceci permet de lier plus simplement structures 107, 108 et couche en matériau électriquement isolant 114. En outre ce procédé de fabrication du blindage 106 assure une bonne maîtrise et reproductibilité de la géométrie et des caractéristiques du blindage 106 et peut donc être plus aisément automatisé.

En référence à la figure 3, la carte à circuit imprimé 201 selon le troisième mode de réalisation de l'invention s'avère identique à celle du premier mode de réalisation à la différence près que la couche en matériau électriquement isolant 214 n'est pas surmoulée sur la deuxième portion et la quatrième portion mais seulement sur la deuxième portion 211. La deuxième structure 207 est alors agencée de sorte que la quatrième portion 213 s'étende au-dessus de la couche en matériau électriquement isolant 214 et de la deuxième portion 211. La quatrième portion 213 peut seulement venir reposer sur la couche en matériau électriquement isolant 214. En variante, la quatrième portion 213 peut être fixée à ladite couche en matériau électriquement isolant 214 par exemple par bouterollage, l'excroissance 221 ainsi formée de la quatrième portion et/ou de la couche en matériau électriquement isolant 214 venant s'insérer respectivement dans la couche en matériau électriquement isolant 214 et/ou la quatrième portion 213 pour fixer quatrième portion 213 et couche en matériau électriquement isolant 214.

Alternativement, la deuxième portion 211 et la quatrième portion 213 peuvent être fixées à la couche en matériau électriquement isolant 214 autrement que par surmoulage par exemple par boutellorage.

Dans tous les cas, la couche en matériau électriquement isolant 214 est ainsi rigidement fixée à la deuxième portion 211 et à la quatrième portion 213. La couche en matériau électriquement isolant 214 et la première structure 207 et la deuxième structure 208 forment donc un tout-rigide.

Ceci permet une bonne maîtrise et reproductibilité de la géométrie et des caractéristiques du blindage 206 de sorte que la production du blindage 206 peut être automatisée relativement aisément. Il s'avère en outre simple de lier ensuite le tout-rigide à la carte à circuit imprimé 201.

De plus, ceci permet de limiter les étapes de surmoulage plus complexes.

Ici la deuxième portion 211 se retrouve englobée dans du matériau électriquement isolant et la quatrième portion 213 se retrouve entourée sur sa face inférieure par du matériau isolant. Alternativement, le blindage 206 peut comporter une deuxième couche en matériau électriquement isolant venant recouvrir la face supérieure de la quatrième portion 213 qui se retrouve ainsi également englobée dans du matériau isolant. Ceci permet d'agencer plus aisément d'autres éléments au-dessus de la quatrième portion 213 (comme une autre carte à circuit imprimée) tout en évitant la rupture de l'isolation galvanique 202.

En référence à la figure 4, dans la carte à circuit imprimé 301 selon le quatrième mode de réalisation de l'invention, chaque structure 307 comporte une feuille en matériau électriquement conducteur présentant chacune plusieurs portions, au moins une portion de chaque feuille s'étendant au-dessus de la face principale de l'isolateur numérique 305 en regard l'une de l'autre pour former la capacité.

Le blindage 306 comporte en outre deux couches en matériau électriquement isolant comprenant chacune une feuille en matériau électriquement isolant : une première feuille d'isolation 322 est ainsi agencée entre l'isolant numérique 305 et la première structure 307 et une deuxième feuille d'isolation 323 est ainsi agencée entre la première structure 307 et la deuxième structure 308 (et donc entre les deux portions correspondantes de sorte à faire partie de la capacité). De la sorte, la portion de la première structure 307 se retrouve englobée dans du matériau électriquement isolant et la portion de la deuxième structure 308 se retrouve entourée sur sa face inférieure par du matériau électriquement isolant.

En variante, le blindage 306 peut comporter une troisième couche en matériau électriquement isolant comprenant une feuille en matériau électriquement isolant agencée sur la face supérieure de la deuxième structure 308 qui se retrouve ainsi également englobée dans du matériau isolant électriquement. Ceci permet d'agencer aisément d'autres éléments au-dessus de la deuxième structure 308 (comme une autre carte à circuit imprimée) tout en évitant la rupture de l'isolation galvanique 302.

Dans ce quatrième mode de réalisation, le blindage 306 comporte donc une superposition de feuilles électriquement conductrices et de feuilles électriquement isolantes.

Ceci permet d'avoir un blindage 306 plus compact.

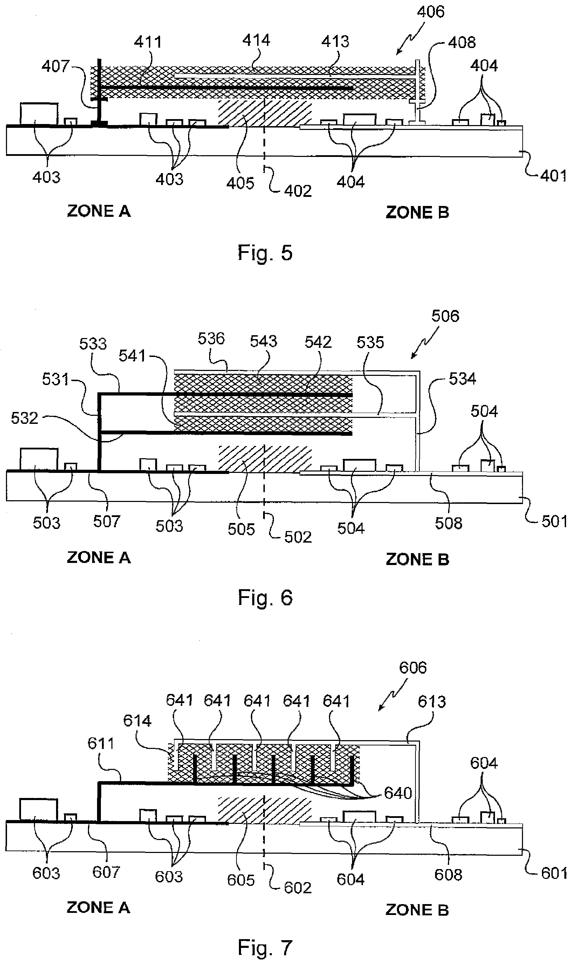

En référence à la figure 5, dans la carte à circuit imprimé 401 selon le cinquième mode de réalisation, le blindage 406 comporte lui-même une carte à circuit imprimé 414 en matériau électriquement isolant (distincte de la carte à circuit imprimé 401 servant de support) et agencée au-dessus de l'isolateur numérique 405. La carte à circuit imprimée 414 est ici en résine époxyde stratifiée renforcée en fibres de verre, par exemple en FR-4 (pour l'anglais « Flame Résistant 4 »).

Les portions 411, 413 des structures formant la capacité sont alors formées par des pistes, par exemple de cuivre, s'étendant à l'intérieur de la carte à circuit imprimé 414. De la sorte, une partie de la carte à circuit imprimée 414 agencée entre lesdites pistes forme directement la couche en matériau électriquement isolant du blindage 406.

Ceci permet de réaliser simplement et à faible coût le blindage 406 tout en assurant une bonne maîtrise et reproductibilité de la géométrie et des caractéristiques du blindage 406. La réalisation d'un tel blindage 406 peut donc être aisément automatisée.

De la sorte, les portions 411, 413 formant la capacité sont entièrement englobées dans du matériau électriquement isolant. Ceci permet ainsi d'agencer plus aisément d'autres éléments au-dessus de la deuxième structure 408 (comme une autre carte à circuit imprimée) tout en évitant la rupture de l'isolation galvanique.

Alternativement, seule la portion 411 de la première structure 407 est agencée à l'intérieur de la carte à circuit imprimé 414 et la portion 413 de la deuxième structure 408 s'étend sur la surface supérieure libre de la carte à circuit imprimé 414.

Dans tous les cas, la couche en matériau électriquement isolant est ainsi rigidement fixée aux deux portions 411, 413. La couche en matériau électriquement isolant et la première structure 407 et la deuxième structure 408 forment donc un tout-rigide facilitant entre autres la manipulation du blindage.

De façon avantageuse, du fait que les portions 411, 413 formant la capacité sont formées par un film fin ou un plan directement dans la carte à circuit imprimé et ne jouent donc plus un rôle structurel important comme par exemple dans le premier mode de réalisation, il est possible de réduire les épaisseurs desdites portions tout en respectant le fait que ces épaisseurs demeurent supérieures à l'épaisseur de peau desdites portions afin d'éviter que les ondes électromagnétiques rayonnées ne traversent lesdites portions vers l'extérieur du blindage 406.

Les différentes portions étant ici en cuivre, on rappelle que l'épaisseur de peau du cuivre pour des fréquences de l'ordre du Gigahertz est d'environ 2 micromètres. Les différentes portions sont donc ici conformées de sorte à présenter une épaisseur d'au moins quelques dizaines de micromètres. Typiquement lesdites portions ont une épaisseur de 40 micromètres.

En référence à la figure 6, alors que dans les autres modes de réalisation les structures ne comportaient chacune qu'une portion venant en regard de la portion de l'autre structure pour former une capacité, dans le sixième mode de réalisation, chaque structure 507, 508 comporte un nombre plus important de portions en regard des portions de l'autre structure pour former plusieurs capacités que l'on peut ici assimilée à une capacité globale.

De façon particulière, la première structure 507 comporte une première portion 531 qui s'étend à partir de la première zone A en regard de l'isolant numérique 505 jusqu'au-dessus de l'isolant numérique 505, une deuxième portion 532 qui s'étend à partir de la première portion 531 au-dessus de la face principale de l'isolateur numérique 505 et une troisième portion 533 qui s'étend à partir de la première portion 531 au-dessus de la deuxième portion 532 et donc de la face principale de l'isolateur numérique 505. La deuxième portion 532 et la troisième portion 533 s'étendent donc ici sensiblement à la perpendiculaire de la première portion 531.

La première portion 531 présente une surface supérieure à la surface de la première face latérale correspondante de l'isolateur numérique 305 de sorte à recouvrir toute la première face latérale de l'isolant numérique 305. La première portion 531 est ici une surface plane.

La deuxième portion 532 et la troisième portion 533 s'étendent ici depuis la première zone A jusqu'à la deuxième zone B, en restant au-dessus de la première zone A et de la deuxième zone B. La deuxième portion 532 et la troisième portion 533 s'étendent ainsi de sorte à avoir une surface supérieure à la surface de la face principale de l'isolateur numérique 505. La deuxième portion 532 et la troisième portion 533 recouvrent donc toute deux la face principale de l'isolateur numérique 505. La deuxième portion 532 et la troisième portion 533 sont ici des surfaces planes.

La deuxième structure 508 comporte ici une quatrième portion 534 qui s'étend à partir de la deuxième zone B en regard de l'isolant numérique 505 jusqu'au-dessus de l'isolant numérique 505, une cinquième portion 535 qui s'étend à partir de la quatrième portion 534 au-dessus de l'isolateur numérique 505 et une sixième portion 506 qui s'étend à partir de la quatrième portion 534 au-dessus de la cinquième portion 535 et donc de la face principale de l'isolateur numérique 505. La cinquième portion 535 et la sixième portion 536 s'étendent donc ici sensiblement à la perpendiculaire de la quatrième portion 534.

La quatrième portion 534 présente une surface supérieure à la surface de la deuxième face latérale correspondante de l'isolateur numérique 505 de sorte à recouvrir toute la deuxième face latérale de l'isolant numérique 505. La quatrième portion 534 est ici une surface plane.

La cinquième portion 535 s'étend ici depuis la deuxième zone B jusqu'à la première zone A entre la deuxième portion 532 et la troisième portion 533, en restant au-dessus de la première zone A et de la deuxième zone B et de la deuxième portion 532. La cinquième portion 535 s'étend ainsi de sorte à avoir une surface supérieure à la surface de la face principale de l'isolateur numérique 505. La cinquième portion 535 recouvre donc toute la face principale de l'isolateur numérique 505. La cinquième portion 535 est ici une surface plane.

La sixième portion 536 s'étend ici depuis la deuxième zone B jusqu'à la première zone A au-dessus de la troisième portion 533, en restant au-dessus de la première zone A et de la deuxième zone B et de la troisième portion 533. La sixième portion 536 s'étend ainsi de sorte à avoir une surface supérieure à la face principale de l'isolateur numérique 505. La sixième portion 536 recouvre donc toute la face principale de l'isolateur numérique 505. La sixième portion 536 est ici une surface plane.

La deuxième portion 532, la troisième portion 533, la cinquième portion 535 et la sixième portion 536 sont en outre agencées de sorte à s'étendre parallèlement les unes par rapport aux autres. De la sorte, ces quatre portions définissent une capacité globale au niveau de leur surface en regard.

Le blindage 506 est donc conformé de sorte à comporter un empilement en hauteur de portions au-dessus de la face principale de l'isolateur numérique 205.

De préférence, le blindage 506 comporte au moins une première couche en matériau électriquement isolant 541 agencée entre la deuxième portion 532 et la cinquième portion 535, une deuxième couche en matériau électriquement isolant 542 agencée entre la cinquième couche 535 et la troisième couche 533 et une troisième couche en matériau électriquement isolant 543 agencée entre la troisième couche 533 et la sixième couche 536 de sorte que ces différents couches viennent combler chaque espace entre deux portions en regard.

Alternativement le blindage 506 peut comporter une seule ou deux couches en matériau électriquement isolant agencées pour combler l'espace entre deux portions en regard.

En référence à la figure 7, le blindage de la carte à circuit imprimé 601 selon le septième mode de réalisation de l'invention est similaire à celui du premier mode de réalisation à la différence près que la deuxième portion et la quatrième portion ne sont pas planes mais sont conformées en peigne.

Les deux structures 607, 608 sont agencées de sorte que les deux peignes se trouvent interposés, à chaque dent 640 du peigne de la deuxième portion 611 succédant une dent 641 du peigne de la quatrième portion 613. Ceci permet de créer une succession de surfaces en regard.

En outre, les surfaces de la deuxième portion 611 et de la quatrième portion 613 portants les dents respectivement de la deuxième portion 611 et de la quatrième portion 613 se trouvent également en regard l'une de l'autre comme pour les autres modes de réalisation.

De la sorte, les surfaces en regard des dents et les surfaces en regard des portions portant lesdites dents forment ainsi une capacité globale.

La structure en forme de peignes de la deuxième portion 611 et de la quatrième portion 614 permet donc avantageusement d'augmenter la surface de la capacité globale, et donc sa valeur, pour un même volume du blindage 606. Ceci s'avère par exemple utile dans le cas où les fréquences à blinder sont plus faibles.

La couche en matériau électriquement isolant 614 s'étend ici entre la deuxième portion 611 et la quatrième portion 613 de sorte à combler l'espace séparant les différentes dents ainsi que l'espace séparant les surfaces portant les dents. De préférence, la couche en matériau électriquement isolant 614 s'étend également pour englober extérieurement les deux dents aux extrémités de la succession de dents.

De façon particulière, les structures 607, 608 sont agencées de sorte que les dents 640, 641 des peignes s'étendent sensiblement à la verticale de l'isolateur numérique 605 et de la carte à circuit imprimé 601.

Bien entendu l'invention n'est pas limitée aux modes de réalisation décrits et on peut y apporter des variantes de réalisation sans sortir du cadre de l'invention tel que défini par les revendications.

En particulier, bien qu'ici le blindage permette de recouvrir un seul composant, le blindage pourra être agencé pour recouvrir plusieurs composants. Ceci permettra ainsi de circonscrire avec un seul blindage les bruits générés par ces différents composants. De façon générale, le blindage permettra de recouvrir un unique composant, plusieurs composants réalisant une même fonction électronique ou plusieurs fonctions électroniques, ou encore un ou plusieurs composants formant un sous-groupe d'un ensemble de composants réalisant une même fonction électronique ou plusieurs fonctions électronique (le reste de l'ensemble étant agencé hors du blindage)... Par ailleurs, tous les composants recouverts par le blindage ne seront pas nécessairement agencés au niveau de la frontière entre deux zones.

Bien qu'ici le support comporte deux zones, le support pourra comporter un plus grand nombre de zones. Dans ce cas, le composant pourra être agencé à la frontière de deux zones ou de plus de deux zones. Le blindage sera alors adapté en conséquence pour blinder au moins la surface supérieure du composant tout en respectant l'isolation galvanique entre les zones. A cet effet, le blindage comprendra autant de structures que de zones sur lesquelles le composant sera agencé de sorte que chaque structure reposera sur une zone différente du support associée au composant.

En outre, bien qu'ici les structures soient agencées pour recouvrir seulement la face principale du composant et deux des quatre faces latérales, les structures pourront bien entendu être agencées pour recouvrir sans se toucher un nombre différent de faces du composant (à condition de recouvrir au moins la face principale) voire l'ensemble des faces du composant. En particulier, le blindage pourra être conformé pour assurer aussi le blindage de la face du composant reposant contre le support en comprenant par exemple deux dispositifs similaires (comprenant chacun au moins deux structures en matériau électriquement conducteur) agencé l'un au-dessus du support et l'autre au-dessous du support de sorte à recouvrir la face principale et la face du composant reposant contre le support. En variante, le blindage pourra comprendre un premier dispositif (comprenant au moins deux structures en matériau électriquement conducteur) agencé au-dessus du support pour assurer le blindage de la face principale et un deuxième dispositif (comprenant au moins deux structures en matériau électriquement conducteur) inséré directement dans le support, le support jouant alors le rôle d'une couche en matériau électriquement conducteur.

Le blindage pourra comporter un nombre plus important de structures que celui indiqué quand bien même le composant ne sera agencé à la frontière que de deux zones du support.

De même, chaque structure pourra comporter un nombre différent de portions que ceux illustrés. En outre, chaque structure pourra comporter plusieurs portions de sorte à associer chaque portion à une seule face du composant et/ou pourra comporter une même portion conformée pour être associée à plusieurs faces du composant.

En outre, bien qu'ici les portions en regard des structures puissent recouvrir seule la face principale du composant, les portions pourront être de dimensions inférieures de sorte à ne pas recouvrir chacune seule la face principale du composant, l'association des portions permettant toutefois ce couvrement. On préférera toutefois avoir des portions dimensionnées pour recouvrir seule la face principale du composant de sorte que la surface en recouvrement soit identique à celle de la face principale ce qui permet d'avoir un blindage plus efficace.

De façon générale, les structures et les portions associées pourront être dans en matériau électriquement conducteur différent de ceux décrits (cuivre, acier ...). L'épaisseur des portions et/ou des structures sera de préférence choisie non seulement en fonction de l'épaisseur de peau du matériau utilisé mais également en fonction de la tenue mécanique du blindage ou/et des conditions environnementales d'utilisation (gammes de températures, humidité, corrosion ...) ...

Par ailleurs, le blindage pourra comporter un nombre différent de couches en matériau électriquement isolant que ceux indiqués. Le blindage pourra ainsi comporter un nombre inférieur, égal ou supérieur de couches en matériau électriquement isolant que de surfaces de recouvrement de portions formant capacité. Une couche en matériau électriquement isolant du blindage pourra ainsi être agencée entre chaque espace entre deux portions en regard.

Bien qu'ici le matériau de la couche en matériau électriquement isolant soit choisi de sorte à présenter une forte résistivité volumique et une forte constante diélectrique, d'autres paramètres pourront en complément ou en remplacement être pris en compte pour choisir le matériau de la couche en matériau électriquement isolant comme la perméabilité du matériau ou ses propriétés thermiques. De façon générale, le matériau de la couche en matériau électriquement isolant pourra être différent de ceux décrits. Par ailleurs, quelle que soit la configuration des structures associées, la couche en matériau électriquement isolant pourra avoir une surface identique à la surface de recouvrement ou avoir une surface plus grande ou inférieure à la surface de recouvrement.

Bien qu'ici différentes solutions (gestion de l'épaisseur des portions, gestion de la taille des ouvertures et gestion de la valeur de la capacité) aient été mises en place simultanément pour assurer que le blindage soit conformé pour bloquer principalement des d'ondes ayant une certaine gamme de fréquences, seule une solution ou une partie seulement de ces solutions pourront être mises en œuvre. En variante, aucune de ces solutions ne sera mise en oeuvre typiquement lorsqu'aucune gamme de fréquences particulière ne sera visée par le blindage.

Alternativement ou en complément, le blindage pourra être conformé pour respecter d'autres critères que le blocage des ondes ayant une certaine gamme de fréquences. Par exemple, dans le cas où le blindage doit également respecter une isolation galvanique, on rappelle qu'une isolation galvanique est testée en pratique par des essais de rigidité diélectrique (tension à la fréquence industrielle et/ou tension de choc) avant une mise en service. On pourra alors dimensionner le blindage de sorte que la capacité du blindage introduise des courants de fuite raisonnables et maîtrisés pour ces essais tout en restant efficace pour bloquer les signaux perturbateurs. Le blindage permettra ainsi d'assurer l'isolation galvanique tout en remplissant sa fonction de blindage haute fréquence, en assurant une continuité pour la gamme de fréquences choisie mais pas, ou peu, pour les fréquences des essais de rigidité diélectrique testant ladite isolation galvanique.

On pourra bien entendu conformer le blindage pour qu'il bloque principalement des ondes ayant une autre gamme de fréquences que celle indiquée.

## Revendications

1. Support (1 ; 101 ; 201 ; 401) comprenant au moins un composant (5 ; 105 ; 205 ; 405) et un blindage (6 ; 106 ; 206 ; 406) dudit composant, le blindage comprenant au moins deux structures distinctes (7,8 ; 107,108 ; 207,208 ; 407,408) en matériau électriquement conducteur qui sont agencées pour recouvrir sans se toucher au moins une face principale du composant, chaque structure comportant une portion (11,13 ; 111,113 ; 211,213 ; 411,413) en matériau électriquement conducteur qui s'étend au-dessus de la face principale du composant en regard de la portion correspondante de l'autre structure, le blindage comportant en outre au moins une couche en matériau électriquement isolant (14 ; 114 ; 214 ; 414) s'étendant entre les deux portions pour former avec lesdites portions une capacité, le support étant **caractérisé en ce que** la couche en matériau électriquement isolant s'étend à l'extérieur d'au moins l'une des portions pour englober au moins ladite portion.

2. Support selon la revendication 1, dans lequel les portions (11,13 ; 111,113 ; 211,213 ; 411,413) ont une surface de recouvrement au moins égale à la surface de la face principale du composant (5 ; 105 ; 205 ; 305 ; 405).

3. Support selon l'une des revendications précédentes, dans lequel le blindage (6 ; 106 ; 206 ; 406) est conformé pour bloquer au moins les rayonnements parasites hautes fréquences générés par le composant (5 ; 105 ; 205 ; 405) .

4. Support selon la revendication 3, dans lequel le blindage (6 ; 106 ; 206 ; 406) est conformé pour bloquer au moins les rayonnements parasites de l'ordre du Gigahertz générés par le composant (5 ; 105 ; 205; 405).

5. Support selon l'une des revendications précédentes, dans lequel les portions en regard sont planes (11,13 ; 111,113 ; 211,213 ; 411,413).

6. Support selon la revendication 1, dans lequel la couche en matériau électriquement isolant (114) comporte au moins une fente (120) ménagée dans ladite couche et dans laquelle est insérée l'une des portions.

7. Support selon l'une des revendications 1 à 6, dans lequel la couche en matériau électriquement isolant (14 ; 214 ; 414) est rigidement fixée à au moins l'une des portions.

8. Support selon la revendication 7, dans lequel la couche en matériau électriquement isolant (14 ; 214) est surmoulée sur au moins l'une des portions.

9. Support selon la revendication 7 ou la revendication 8, dans lequel au moins l'une des portions est fixée à la couche en matériau électriquement isolant (221) par bouterollage.

10. Support selon l'une des revendications 1 à 9, dans lequel le blindage (406) comporte une carte à circuit imprimé en matériau électriquement isolant, au moins une portion étant une piste formée dans la carte à circuit imprimé, une partie de la carte à circuit imprimée en regard de ladite portion formant alors directement la couche en matériau électriquement isolant du blindage.

11. Support selon l'une selon l'une des revendications 1 à 10, dans lequel la couche en matériau électriquement isolant (14 ; 214 ; 414) est rigidement fixée aux deux structures de sorte à former avec lesdites structures un tout-rigide.

12. Support selon l'une des revendications précédentes, dans lequel au moins l'une des structures comporte plusieurs portions en matériau électriquement conducteur qui s'étendent au-dessus de la face principale du composant en regard de la portion correspondante de l'autre structure.

13. Support selon l'une des revendications précédentes, dans lequel les portions en regard sont conformées en forme de peignes, les deux structures étant agencées de sorte que les peignes se trouvent interposés.

14. Support selon l'une des revendications 1 à 12, dans lequel la couche en matériau électriquement isolant (14 ; 114 ; 214 ; 414) s'étend parallèlement à la face principale du composant.

15. Support selon l'une des revendications précédentes, dans lequel au moins l'une des portions (411, 413) est en cuivre.

16. Support selon l'une des revendications précédentes, dans lequel au moins l'une des portions (11,13 ; 111,113 ; 211,213) est en acier.

17. Support selon l'une des revendications 1 à 11 ou 14 ou 15, dans lequel la couche en matériau électriquement isolant (414) est en résine époxyde stratifiée renforcée en fibres de verre.

18. Support selon l'une des revendications 1 à 11 ou 14 à 16, dans lequel la couche en matériau électriquement isolant (14 ; 114 ; 214) est en polyamide renforcé en fibre de verre.

19. Support selon l'une des revendications précédentes, dans lequel le blindage (6 ; 106 ; 206 ; 406) ne comporte que deux structures.

20. Support selon l'une des revendications précédentes, dans lequel le support (1 ; 101 ; 201 ; 401) comprend plusieurs zones séparées entre elles par isolation galvanique, le composant étant agencé à cheval sur plusieurs zones du support, le blindage comprenant autant de structures que de zones sur lesquelles le composant est agencé de sorte que chaque structure repose sur une zone différente du support associée au composant.

## Patentansprüche

1. Träger (1; 101; 201; 401), umfassend mindestens ein Bauelement (5; 105; 205; 405) und eine Abschirmung (6; 106; 206; 406) für das genannte Bauelement, wobei die Abschirmung mindestens zwei separate Strukturen (7, 8; 107, 108; 207, 208; 407, 408) aus elektrisch leitendem Material umfasst, die so angeordnet sind, dass sie, ohne sich zu berühren, mindestens eine Hauptfläche des Bauelements überdecken, wobei jede Struktur einen Abschnitt (11, 13; 111, 113; 211, 213; 411, 413) aus elektrisch leitendem Material umfasst, der sich über der Hauptfläche des Bauelements gegenüber dem entsprechenden Abschnitt der anderen Struktur erstreckt, wobei die Abschirmung ferner mindestens eine Schicht aus elektrisch isolierendem Material (14; 114; 214; 414) umfasst, die sich zwischen den beiden Abschnitten erstreckt, um mit den genannten Abschnitten eine Kapazität zu bilden, wobei der Träger **dadurch gekennzeichnet ist, dass** sich die Schicht aus elektrisch isolierendem Material außerhalb mindestens eines der Abschnitte erstreckt, um mindestens den genannten Abschnitt einzuschließen.

2. Träger nach Anspruch 1, bei dem die Abschnitte (11, 13; 111, 113; 211, 213; 411, 413) eine Abdeckungsfläche mindestens gleich der Oberfläche der Hauptfläche des Bauelements (5; 105; 205; 305; 405) haben.

3. Träger nach einem der vorhergehenden Ansprüche, bei dem die Abschirmung (6; 106; 206; 406) so geformt ist, dass sie mindestens die hochfrequenten Störstrahlungen blockiert, die von dem Bauelement (5; 105; 205; 405) erzeugt werden.

4. Träger nach Anspruch 3, bei dem die Abschirmung (6; 106; 206; 406) ausgebildet ist, mindestens die Störstrahlungen im Gigahertz-Bereich zu blockieren, die von dem Bauelement (5; 105; 205; 405) erzeugt werden.

5. Träger nach einem der vorhergehenden Ansprüche, bei dem die gegenüberliegenden Abschnitte eben sind (11, 13; 111, 113; 211, 213; 411, 413).

6. Träger nach Anspruch 1, bei dem die Schicht aus elektrisch isolierendem Material (114) mindestens einen Schlitz (120) umfasst, der in der genannten Schicht ausgebildet ist und in den einer der Abschnitte eingefügt ist.

7. Träger nach einem der Ansprüche 1 bis 6, bei dem die Schicht aus elektrisch isolierendem Material (14; 214; 414) starr an mindestens einem der Abschnitte befestigt ist.

8. Träger nach Anspruch 7, bei dem die Schicht aus elektrisch isolierendem Material (14; 214) auf mindestens einen der Abschnitte aufgeformt ist.

9. Träger nach Anspruch 7 oder Anspruch 8, bei dem mindestens einer der Abschnitte an der Schicht aus elektrisch isolierendem Material (221) mittels Vernietung befestigt ist.

10. Träger nach einem der Ansprüche 1 bis 9, bei dem die Abschirmung (406) eine Leiterplatte aus elektrisch isolierendem Material umfasst, wobei mindestens ein Abschnitt eine Bahn ist, die in der Leiterplatte ausgebildet ist, wobei ein Teil der Leiterplatte, der dem genannten Abschnitt gegenüberliegt, dann direkt die Schicht aus elektrisch isolierendem Material der Abschirmung bildet.

11. Träger nach einem der Ansprüche 1 bis 10, bei dem die Schicht aus elektrisch isolierendem Material (14; 214; 414) starr an den beiden Strukturen derart befestigt ist, dass sie mit den genannten Strukturen eine feste Einheit bildet.

12. Träger nach einem der vorhergehenden Ansprüche, bei dem mindestens eine der Strukturen mehrere Abschnitte aus elektrisch leitendem Material umfasst, die sich über der Hauptfläche des Bauelements gegenüber dem entsprechenden Abschnitt der anderen Struktur erstrecken.

13. Träger nach einem der vorhergehenden Ansprüche, bei dem die gegenüberliegenden Abschnitte in Form von Kämmen geformt sind, wobei die beiden Strukturen so angeordnet sind, dass sich die Kämme dazwischen befinden.

14. Träger nach einem der Ansprüche 1 bis 12, bei dem sich die Schicht aus elektrisch isolierendem Material (14; 114; 214; 414) parallel zur Hauptfläche des Bauelements erstreckt.

15. Träger nach einem der vorhergehenden Ansprüche, bei dem mindestens einer der Abschnitte (411, 413) aus Kupfer ist.

16. Träger nach einem der vorhergehenden Ansprüche, bei dem mindestens einer der Abschnitte (11, 13; 111, 113; 211, 213) aus Stahl ist.

17. Träger nach einem der Ansprüche 1 bis 11 oder 14 oder 15, bei dem die Schicht aus elektrisch isolierendem Material (414) aus laminiertem glasfaserverstärktem Epoxidharz ist.

18. Träger nach einem der Ansprüche 1 bis 11 oder 14 bis 16, bei dem die Schicht aus elektrisch isolierendem Material (14; 114; 214) aus glasfaserverstärktem Polyamid ist.

19. Träger nach einem der vorhergehenden Ansprüche, bei dem die Abschirmung (6; 106; 206; 406) nur zwei Strukturen umfasst.

20. Träger nach einem der vorhergehenden Ansprüche, bei dem der Träger (1; 101; 201; 401) mehrere durch galvanische Trennung voneinander getrennte Zonen umfasst, wobei das Bauelement über mehrere Zonen des Trägers hinweg angeordnet ist, wobei die Abschirmung so viele Strukturen wie Zonen umfasst, auf denen das Bauelement angeordnet ist, sodass jede Struktur auf einer anderen Zone des Trägers liegt, die mit dem Bauelement verbunden ist.

## Claims

1. A support (1; 101; 201; 401) comprising at least one component (5; 105; 205; 405) and shielding (6; 106; 206; 406) for said component, the shielding comprising at least two distinct structures (7, 8; 107, 108; 207, 208; 407, 408) of electrically conductive material that are arranged to cover at least a main face of the component, without touching each other, each structure having a portion (11, 13; 111, 113; 211, 213; 411, 413) of electrically conductive material that extends over the main face of the component and facing the corresponding portion of the other structure, the shielding further including at least one layer of electrically insulating material (14; 114; 214; 414) extending between the two portions in order to co-operate with said portions to form a capacitor, the support being **characterized in that** the layer of electrically insulating material extends outside at least one of the portions in order to encompass at least said portion.

2. A support according to claim 1, wherein the portions (11, 13; 111, 113; 211, 213; 411, 413) have an overlap area that is not less than the area of the main face of the component (5; 105; 205; 305; 405).

3. A support according to either preceding claim, wherein the shielding (6; 106; 206; 406) is shaped to block at least interfering radiation at high frequency generated by the component (5; 105; 205; 405).

4. A support according to claim 3, wherein the shielding (6; 106; 206; 406) is shaped to block at least interfering radiation of gigahertz order generated by the component (5; 105; 205; 405).

5. A support according to any preceding claim, wherein the facing portions (11, 13; 111, 113; 211, 213; 411, 413) are plane.

6. A support according to claim 1, wherein the layer of electrically insulating material (114) has at least one slot (120) arranged in said layer, and in which one of the portions is inserted.

7. A support according to any one of claims 1 to 6, wherein the layer of electrically insulating material (14; 214; 414) is rigidly fastened to at least one of the portions.

8. A support according to claim 7, wherein the layer of electrically insulating material (14; 214) is overmolded on at least one of the portions.

9. A support according to claim 7 or claim 8, wherein at least one of the portions is fastened to the layer of electrically insulating material (221) by heading.

10. A support according to any one of claims 1 to 9, wherein the shielding (406) comprises a printed circuit card of electrically insulating material, at least one portion being a track formed in the printed circuit card, a part of the printed circuit card facing said portion then directly forming the layer of electrically insulating material of the shielding.

11. A support according to any one of claims 1 to 10, wherein the layer of electrically insulating material (14; 214; 414) is rigidly fastened to two structures so as to co-operate with said structures to form a rigid unit.

12. A support according to any preceding claim, wherein at least one of the structures comprises a plurality of portions of electrically insulating material extending over the main face of the component facing the corresponding portion of the other structure.

13. A support according to any preceding claim, wherein the facing portions are shaped in the form of combs, the two structures being arranged so that the combs are interposed.

14. A support according to any one of claims 1 to 12, wherein the layer of printed circuit card (14; 114; 214; 414) extends parallel to the main face of the component.

15. A support according to any preceding claim, wherein at least one of the portions (411, 413) is made of copper.

16. A support according to any preceding claim, wherein at least one of the portions (11, 13; 111, 113; 211, 213) is made of steel.

17. A support according to any one of claims 1 to 11 or 14 or 15, wherein the layer of electrically insulating material (414) is made of fiberglass-reinforced laminated epoxy resin.

18. A support according to any one of claims 1 to 11 or 14 to 16, wherein the layer of electrically insulating material (14; 114; 214) is made of fiberglass-reinforced polyamide.

19. A support according to any preceding claim, wherein the shielding (6; 106; 206; 406) comprises only two structures.

20. A support according to any preceding claim, wherein the support (1; 101; 201; 401) has a plurality of zones that are separated from one another by electrical isolation, the component being arranged over a plurality of zones of the support, the shielding comprising as many structures as there are zones on which the component is arranged such that each structure stands on a different zone of the support associated with the component.
